# FASCICULE DE BREVET EUROPEEN

(11) **EP 4 793 756 B1**
(45) Date de publication et mention de la délivrance du brevet: **25.11.2026**
(21) Numéro de dépôt: 26158034.4
(22) Date de dépôt: 12.02.2026
(51) Int. Cl.: G06F 7/58, H10N 50/10

(54) **ARCHITECTURE DE DETECTION D'UN DISPOSITIF SPINTRONIQUE A BIT PROBABILISTE**
DETEKTIONSARCHITEKTUR EINES PROBABILISTISCHEN BIT-SPINTRONIC-GERÄTS
DETECTION ARCHITECTURE OF A PROBABILISTIC BIT SPINTRONIC DEVICE

(30) Priorité: 13.02.2025 FR 2501492
(43) Date de publication de la demande: 19.08.2026
(73) Titulaire: Commissariat à l'Energie Atomique et aux Energies Alternatives, 75015 Paris (FR); Centre National de la Recherche Scientifique, 75016 Paris (FR); Université Grenoble Alpes, 38400 Saint-Martin-d'Hères (FR); Institut Polytechnique de Grenoble, 38000 Grenoble (FR)
(72) Inventeur: DANOUCHI, Kamal, 38054 Grenoble Cedex 09 (FR); HUTIN, Louis, 38054 Grenoble Cedex 09 (FR); PRENAT, Guillaume, 38054 Grenoble Cedex 09 (FR)
(74) Mandataire: Atout PI Laplace

(56) Documents cités:
- US-A1- 2023 189 659
- SHUVRO CHOWDHURY ET AL: "A full-stack view of probabilistic computing with p-bits: devices, architectures and algorithms", ARXIV.ORG, CORNELL UNIVERSITY LIBRARY, 201 OLIN LIBRARY CORNELL UNIVERSITY ITHACA, NY 14853, 16 March 2023 (2023-03-16), XP091456544, DOI: 10.1109/JXCDC.2023.3256981
- CAMSARI KEREM YUNUS ET AL: "Implementing p-bits With Embedded MTJ", IEEE ELECTRON DEVICE LETTERS, vol. 38, no. 12, 1 December 2017 (2017-12-01), USA, pages 1767 - 1770, XP093329453, ISSN: 0741-3106, DOI: 10.1109/LED.2017.2768321

## Description

### Champ d'application

L'invention concerne un dispositif spintronique à bit probabiliste basé sur une unité stochastique consistant en une jonction tunnel magnétique. Plus particulièrement, l'invention concerne une architecture particulière de détection de l'état de l'unité stochastique permettant d'améliorer la précision de lecture du bit probabiliste.

Un générateur de bit probabiliste est un dispositif qui génère une série de bits (sorties binaires de type 0 ou 1) de manière aléatoire en se basant sur des phénomènes physiques ou quantiques, assurant ainsi un niveau d'aléa ou d'entropie déterminé. Contrairement aux dispositifs classiques qui produisent des résultats déterministes, ce type de dispositif produit un 0 ou un 1 selon une probabilité ajustable en fonction des besoins de l'application. Ce type de sortie probabiliste est essentiel dans des domaines tels que la cryptographie, les algorithmes probabilistes et les simulations, où la génération de valeurs binaires aléatoires garantit la sécurité ou la représentativité des calculs. Cela signifie qu'au lieu de donner systématiquement un 0 ou un 1 de manière déterministe, le dispositif génère une série de bits pendant une durée prédéterminée dans laquelle la distribution entre des bits de 0 et des bits de 1 peut être contrôlée ou prédéfinie via des paramètres d'entrée. Par exemple, on pourrait définir une probabilité de 0,7 pour obtenir un 1 et de 0,3 pour obtenir un 0, ce qui produirait une distribution dans une série de bits (bit word en anglais) où environ 70 % des bits sont des 1 et 30 % sont des 0. Cette distribution probabiliste distingue le générateur de bit probabiliste des générateurs de nombres pseudo-aléatoires, car il s'appuie sur des sources d'incertitude physique (comme le bruit quantique ou thermique ou magnétique), produisant un véritable aléa au niveau des bits.

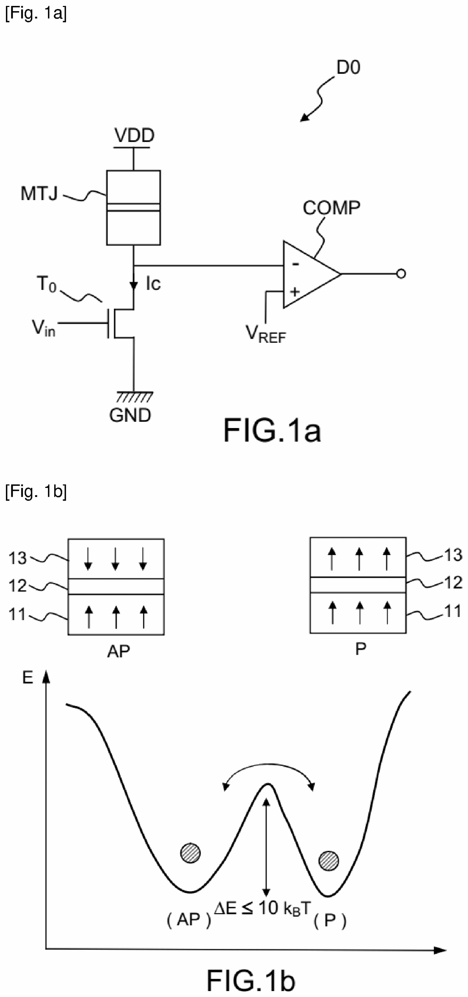

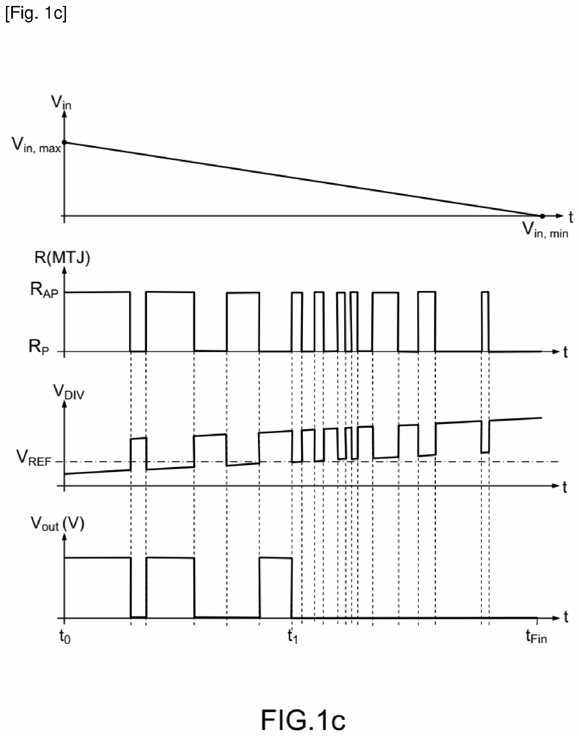

Les dispositifs générateurs de bit probabiliste à base de jonction tunnel magnétique présentent une solution prometteuse pour exploiter les fluctuations de l'état de polarisation magnétique dans une telle structure. La figure 1a illustre le schéma électrique d'un générateur de bit probabiliste D0 selon l'état de l'art. Le générateur de bit probabiliste D0 comprend une jonction tunnel magnétique MTJ, un transistor de contrôle T₀ et un comparateur COMP. La jonction tunnel magnétique MTJ est un pilier magnéto résistif comprenant un empilement de couches 11,12,13. L'empilement comprend une première couche 11 ferromagnétique de référence dans laquelle la direction de la polarisation magnétique est fixe et uniforme. L'empilement comprend en outre une seconde couche 13 ferromagnétique dans laquelle la direction de la polarisation magnétique est variable. L'empilement comprend en outre une couche barrière 12 d'oxyde confinée entre la première et la seconde couche ferromagnétique 11,13. La couche barrière 12 joue un rôle crucial dans l'effet tunnel magnétorésistif, permettant aux électrons de traverser par effet tunnel quantique. La première couche ferromagnétique 11 sert de référence pour détecter les changements de magnétisation dans la couche ferromagnétique libre 13. Le principe de fonctionnement du pilier MTJ magnétorésistif repose sur le changement de la résistance électrique en fonction de l'orientation de polarisation magnétique de la couche ferromagnétique libre 13 par rapport à celle dans la couche ferromagnétique de référence 11. Lorsque les aimantations des couches libres et de référence 11,13 sont parallèles, la résistance électrique est faible et on parle d'un état résistif bas P. Lorsque les aimantations sont antiparallèles, la résistance électrique est élevée et on parle d'un état résistif haut AP. Le dimensionnement de la jonction tunnel magnétique MTJ est tel que les moments magnétiques des couches fluctuent entre différentes orientations sous l'influence des fluctuations thermiques, même en l'absence de champ magnétique externe. Ces fluctuations sont suffisamment importantes par rapport à la barrière d'énergie qui sépare les deux états résistifs, pour que la magnétisation ne soit plus stable dans une direction fixe. On parle ici d'un fonctionnement en « régime de fluctuation » ou d'un état « superparamagnétique », contrairement aux mémoires magnétorésistives où les couches magnétiques conservent leur orientation suite à une programmation. En effet, dans une mémoire magnétorésistive la barrière d'énergie entre les deux états résistifs est hors de portée des variations de l'énergie thermique avec une amplitude supérieure à 40xk_{B}T avec k_{B} la constante de Boltzmann et T la température du fonctionnement de la mémoire. Le fonctionnement de la jonction tunnel superparamagnétique MTJ est illustré par le diagramme d'énergie de la figure 1b qui illustre un premier état résistif P et un second état résistif AP séparés par une barrière d'énergie ΔE inférieure ou égale à dix fois l'énergie thermique k_{B}T, avec k_{B} la constante de Boltzmann et T la température du fonctionnement du générateur D0. La probabilité respective de génération de bits 0 (état résistif haut ou inversement selon la convention choisie) et de bits 1 (état résistif bas ou inversement selon la convention choisie) par la jonction tunnel magnétique MTJ dépend de l'intensité du courant de polarisation Ic qui la traverse. L'intensité du courant Ic est régulée par le transistor de contrôle T₀ monté en série avec la jonction tunnel magnétique MTJ entre un nœud d'alimentation fournissant la tension d'alimentation VDD et la masse électrique GND. Le nœud commun entre jonction tunnel magnétique MTJ et le transistor de contrôle T₀ forme un premier nœud de détection NC1. Le comparateur COMP est configuré pour comparer la chute de tension à travers la jonction tunnel magnétique, correspondant au potentiel électrique V_{DIV} du premier nœud de détection NC1, avec une tension de référence V_{REF}, pour déterminer en continu l'état résistif aléatoire de ladite jonction tunnel magnétique.

Le courant de polarisation Ic est commandé par la tension d'entrée Vᵢₙ appliquée sur la grille du transistor de contrôle T₀. La tension d'entrée Vᵢₙ est avantageusement choisie de manière à fonctionner en régime linéaire ou en régime ohmique. L'augmentation de la tension d'entrée Vᵢₙ engendre l'augmentation du courant de polarisation Ic. L'augmentation du courant de polarisation Ic induit l'augmentation de la probabilité P(1) d'avoir un état résistif haut AP (équivalent à un bit « 1 » de manière conventionnelle non limitative). Inversement, la diminution du courant de polarisation Ic induit l'augmentation de la probabilité P(0) d'avoir un état résistif bas P (équivalent à un bit « 0 » de manière conventionnelle non limitative).

Dans ce contexte, un problème technique majeur est rencontré, à savoir la dérive du mode commun du potentiel électrique variable du premier nœud de détection NC1 en combinaison avec la faible amplitude des variations du potentiel V_{DIV} électrique du premier nœud de détection NC1. Afin de comprendre le problème technique, la figure 1c illustre la variation des différents signaux du générateur de bit probabiliste D0 en réponse à une variation linéaire décroissante de la tension d'entrée Vᵢₙ. Soit V_{in,min} la tension de contrôle permettant d'obtenir la distribution de P(0)=99% P(1)=1%, avec P(0) la probabilité d'avoir un bit 0 et P(1) la probabilité d'avoir un bit. Soit V_{in,max} la tension de contrôle permettant d'obtenir la distribution de P(0)=1% P(1)=99%. La tension d'entrée Vᵢₙ varie de manière linéaire décroissante entre V_{in,max} et V_{in,min}. La variation de la tension d'entrée Vᵢₙ induit une variation de la résistance de la jonction tunnel superparamagnétique MTJ entre un état haut et un état bas avec une distribution de probabilité qui dépend de l'amplitude de la tension d'entrée Vᵢₙ. Ceci induit la variation de la tension V_{DIV} du premier nœud de détection NC1 entre un état haut et un état bas. On obtient ainsi un signal V_{DIV} variable entre deux valeurs de tension. Il a été observé que le mode commun Cₘₘ de la tension V_{DIV} n'est pas constant puisqu'il est inversement proportionnel à la tension d'entrée Vᵢₙ . La dépendance du mode commun Cₘₘ de la tension d'entrée Vᵢₙ induit une dérive de l'enveloppe de la tension V_{DIV} par rapport à la tension de référence constante V_{REF}. En plus, la plage de variation de la tension de détection V_{DIV} entre les deux états est limitée avec une amplitude inférieure à 20mV. Le phénomène de dérive du mode commun Cₘₘ en combinaison avec la plage dynamique étroite de la tension de détection V_{DIV} fait que la fonction de comparaison n'est plus fiable à cause du décrochage dudit signal de détection par rapport à la tension de référence V_{REF} comme illustré sur le signal de détection Vₒᵤₜ à partir de l'instant de décrochage t₁.

Pour pallier les limitations des solutions existantes, l'invention propose un dispositif spintronique ayant une chaine de détection comprenant un élément capacitif C1 entre un premier nœud de détection et un second nœud de détection et un circuit de détection recevant le potentiel du second nœud de détection. Contrairement aux générateurs traditionnels, l'architecture de détection proposée neutralise les effets de dérive du mode commun de la tension au niveau du nœud de détection directement relié à la jonction tunnel magnétique. Cette approche garantit une lecture des bits plus fiable sur l'ensemble de la plage dynamique de la tension d'entrée Vᵢₙ ou du courant d'entrée Iᵢₙ. L'innovation se traduit par une amélioration notable de la fiabilité, de la précision de détection et de la robustesse face aux phénomènes de variabilité de procédé et de température, surpassant ainsi les solutions existantes.

L'invention a pour objet un dispositif spintronique comprenant :
- une jonction tunnel magnétique ayant une résistance qui fluctue entre au moins deux états résistifs distincts selon sa magnétisation ;
- un transistor de contrôle monté en série avec la jonction tunnel magnétique entre un nœud d'alimentation et la masse électrique ; le nœud commun entre le transistor de contrôle et la jonction tunnel magnétique constituant un premier nœud de détection ;
- un élément capacitif connecté entre le premier nœud de détection et un second nœud de détection ;
- un circuit de détection ayant une première entrée connectée au second nœud de détection et configuré pour générer un signal de détection variable selon l'état résistif de la jonction tunnel magnétique à partir du potentiel électrique du second nœud de détection.

Selon un aspect particulier de l'invention, le circuit de détection est configuré pour comparer le potentiel électrique du second nœud de détection avec une tension de seuil prédéterminée.

Selon un aspect particulier de l'invention, le dispositif comprend en outre un premier transistor de polarisation monté entre le second nœud de détection et le nœud d'alimentation ; le premier transistor de polarisation étant commandé par une première tension de polarisation appliquée sur sa grille et choisie pour maintenir le premier transistor de polarisation en régime de saturation.

Selon un aspect particulier de l'invention, le dispositif comprend en outre un circuit calculateur configuré pour générer un bit probabiliste à partir du signal de détection par échantillonnage ou par calcul de moyenne en déterminant la proportion de chaque état résistif de la jonction tunnel magnétique pendant une période prédéterminée.

Selon un aspect particulier de l'invention, la jonction tunnel magnétique est une jonction tunnel super-paramagnétique.

Selon un aspect particulier de l'invention, la jonction tunnel magnétique est disposée sur une piste d'écriture en un matériau à effet Hall de spin ou un matériau à effet Hall orbital.

Selon un aspect particulier de l'invention, le circuit de détection est un inverseur et la tension de seuil prédéterminée est le seuil de commutation dudit inverseur.

Selon un aspect particulier de l'invention, le circuit de détection est un comparateur ayant une première entrée connectée au second nœud de détection et une seconde entrée destinée à recevoir une tension de référence et un nœud de sortie pour générer le signal de détection.

Selon un aspect particulier de l'invention, le dispositif comprend en outre un second transistor de polarisation monté entre la seconde entrée du comparateur et le nœud d'alimentation ; la grille du second transistor de polarisation étant connectée au premier nœud de détection.

Selon un aspect particulier de l'invention, la capacité de l'élément capacitif est inférieure ou égale à 20pF.

Selon un aspect particulier de l'invention, la capacité de l'élément capacitif est comprise entre 5pF et 10pF.

Selon un aspect particulier de l'invention, la jonction tunnel magnétique comprend :
- une première couche ferromagnétique de référence dans laquelle la direction de la polarisation magnétique est fixe ;
- une seconde couche ferromagnétique dans laquelle la direction de la polarisation magnétique est variable ;
- une couche barrière tunnel d'oxyde confinée entre la première et la seconde couche ferromagnétique.

Selon un aspect particulier de l'invention, l'épaisseur de la seconde couche est inférieure à 100 nm.

Selon un aspect particulier de l'invention, le diamètre de la jonction tunnel magnétique est inférieur à 10 nm.

Selon un aspect particulier de l'invention, le dispositif comprend en outre un miroir de courant, ledit miroir de courant comprenant une première branche d'alimentation couplée à une seconde branche d'alimentation ; la seconde branche d'alimentation comprenant au moins le transistor de contrôle et la jonction tunnel magnétique montés en série.

D'autres caractéristiques et avantages de la présente invention apparaîtront mieux à la lecture de la description qui suit en relation aux dessins annexés suivants.

La figure 1a illustre un générateur D0 de bit probabiliste selon l'état de l'art. Cette figure a déjà été décrite.

La figure 1b illustre un diagramme d'énergie du générateur D0 de bit probabiliste selon l'état de l'art. Cette figure a déjà été décrite.

La figure 1c illustre la variation des différents signaux du générateur de bit probabiliste selon l'état de l'art en réponse à une variation linéaire de la tension d'entrée. Cette figure a déjà été décrite.

La figure 2a illustre un générateur D1 de bit probabiliste selon un premier mode de réalisation de l'invention.

La figure 2b illustre la variation des différents signaux du générateur de bit probabiliste selon un premier mode de réalisation de l'invention en réponse à une variation linéaire de la tension d'entrée.

La figure 3 illustre un générateur D1 de bit probabiliste selon un deuxième mode de réalisation de l'invention.

La figure 4a illustre un générateur D1 de bit probabiliste selon un troisième mode de réalisation de l'invention.

La figure 4b illustre la variation des différents signaux du générateur de bit probabiliste selon un troisième mode de réalisation de l'invention en réponse à une variation linéaire de la tension d'entrée.

La figure 5 illustre un générateur D1 de bit probabiliste selon un quatrième mode de réalisation de l'invention.

La figure 6 illustre un générateur D1 de bit probabiliste selon un cinquième mode de réalisation de l'invention.

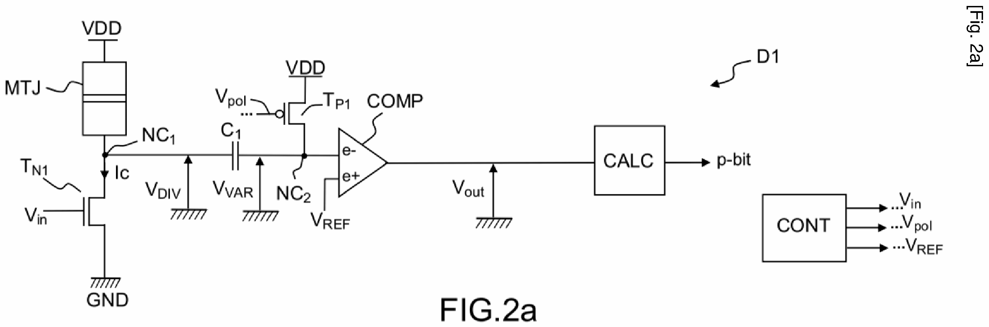

La figure 2a illustre un dispositif spintronique et plus particulièrement un générateur de bit probabiliste D1 selon un premier mode de réalisation de l'invention. Le générateur D1 de bit probabiliste p-bit comprend une jonction tunnel magnétique MTJ, un transistor de contrôle T_{N1}, un circuit de détection COMP, un circuit calculateur CALC et un élément capacitif C₁. La jonction tunnel magnétique MTJ est dimensionnée de manière à fonctionner en régime de fluctuation en réponse à l'agitation thermique. La jonction tunnel magnétique MTJ est formée par un empilement de couches. L'empilement comprend une première couche 11 ferromagnétique de référence dans laquelle la direction de la polarisation magnétique est fixe et uniforme. L'empilement comprend en outre une seconde couche 13 ferromagnétique dans laquelle la direction de la polarisation magnétique est variable. L'empilement comprend en outre une couche barrière 12 d'oxyde confinée entre la première et la seconde couche ferromagnétique 11,13. Le diamètre (ou la diagonale selon la forme) de la jonction tunnel magnétique MTJ est inférieur à 100 nm. Plus avantageusement, l'épaisseur de la seconde couche 13 est inférieure à 10 nm, de préférence inférieure à 5 nm. Cela permet d'abaisser la barrière d'énergie séparant le premier état résistif P et le second état résistif AP à une valeur inférieure ou égale à dix fois l'énergie thermique k_{B}T et donc de réaliser une jonction tunnel super-paramagnétique MTJ. Pour rappel, une jonction tunnel super-paramagnétique présente un état résistif fluctuant où la magnétisation est instable sous l'influence thermique.

A titre illustratif non limitatif, le transistor de contrôle T_{N1} est un transistor à effet de champs de type NMOS. Le transistor de contrôle T_{N1} est configuré pour injecter un courant de commande Ic à travers la jonction tunnel magnétique MTJ de manière à contrôler la distribution entre les deux états résistifs de la jonction tunnel super-paramagnétique MTJ. Le transistor de contrôle T_{N1} monté en série avec la jonction tunnel magnétique MTJ entre un nœud d'alimentation fournissant la tension d'alimentation VDD et la masse électrique GND. L'augmentation du courant de polarisation Ic induit l'augmentation de la probabilité P(1) d'avoir un état résistif haut AP (équivalent à un bit « 1 »). Inversement, la diminution du courant de polarisation Ic induit l'augmentation de la probabilité P(0) d'avoir un état résistif bas P (équivalent à un bit « 0 »). Le contrôle du courant de polarisation Ic est réalisé par l'application d'une tension d'entrée Vᵢₙ sur la grille du transistor de contrôle T_{N1.} Le générateur D1 comprend des moyens de contrôle CONT configurés pour appliquer la tension d'entrée Vᵢₙ variable sur la grille du transistor de contrôle T_{N1}. Avantageusement, la plage de variation de la tension d'entrée Vᵢₙ est choisie telle que le transistor de contrôle fonctionne sous régime ohmique pour assurer un comportement linéaire du générateur.

Le nœud commun entre le transistor de contrôle T_{N1} et la jonction tunnel magnétique MTJ forme un premier nœud de détection NC1. Le potentiel V_{DIV} du premier nœud de détection NC1 varie en créneau selon la chute de tension à travers la jonction tunnel magnétique MTJ qui dépend de la valeur de résistance de ladite jonction. Lorsque la jonction tunnel magnétique MTJ est à un état résistif haut AP, la tension V_{DIV} est à une tension basse, et lorsque la jonction tunnel magnétique MTJ est à un état résistif bas P, la tension V_{DIV} est à une tension haute. L'élément capacitif C1 est monté entre le premier nœud de détection NC1 et un second nœud de détection NC2. Le circuit de détection DET est configuré pour générer un signal de détection Vₒᵤₜ variable selon l'état résistif de la jonction tunnel magnétique MTJ à partir du potentiel V_{VAR} du second nœud de détection NC2. Le circuit de détection DET est configuré pour comparer le potentiel V_{VAR} du second nœud de détection NC2 par rapport à une tension de seuil prédéterminée. Ce montage permet de résoudre le problème du manque de précision de la détection à cause de la dérive du potentiel V_{DIV} du premier nœud de détection. En effet, l'élément capacitif C1 permet d'éliminer la dépendance du mode commun Cₘₘ de la tension d'entrée Vᵢₙ sur le second nœud de détection NC2. L'élément capacitif C1 filtre les variations à basse fréquence correspondant à la dérive et en laisse passer les variations à haute fréquence correspondant aux fluctuations de l'état résistif de la jonction tunnel MTJ. Ainsi, le signal V_{VAR} du second nœud de détection NC2 reproduit les variations de la tension V_{DIV} par charge et décharge de l'élément capacitif C1 tout en le maintenant à un mode commun Cₘₘ. L'utilisation du potentiel V_{VAR} du second nœud de détection NC2 par le circuit de détection permet ainsi de détecter les variations de l'état résistif de la jonction sur toute la plage de variation du signal d'entrée Vᵢₙ étant donné que le signal V_{VAR} du second nœud de détection NC2 est toujours centré autour de la tension de seuil prédéterminée.

Avantageusement, l'élément capacitif C1 présente une capacité inférieure ou égale à 20pF pour pouvoir suivre les variations rapides de la tension V_{DIV} résultants des fluctuations de la résistance R(MTJ) de la jonction tunnel magnétique MTJ. Une capacité supérieure à 20pF signifie que le circuit met plus de temps à s'adapter aux changements, ce qui entraîne une dérive du potentiel au fil du temps, car l'élément capacitif C1 accumule la charge et se décharge plus lentement par rapport aux fluctuations de la jonction tunnel magnétique MTJ.

De manière plus avantageuse, l'élément capacitif C1 présente une capacité supérieure ou égale à 5pF et inférieure ou égale à 10pF. Cette plage spécifique permet d'avoir un compromis entre d'une part un filtrage efficace de la dérive du mode commun Cₘₘ de la tension V_{DIV} et d'autre part une constante de temps assez courte pour pouvoir suivre la fréquence des fluctuations de la résistance R(MTJ).

Dans le premier mode de réalisation, le circuit de détection DET est constitué d'un comparateur COMP. Le comparateur COMP comprend une première entrée e-connectée au second nœud de détection NC2 ; et une seconde entrée recevant la tension de référence V_{REF}. Dans l'exemple illustré et de manière non-limitative, la première entrée e- est l'entrée inverseuse du comparateur et la seconde entrée e+ est l'entrée non-inverseuse. Ainsi, lorsque la jonction tunnel magnétique MTJ est à un état résistif haut AP, la tension reçue par la première entrée du comparateur est inférieure à la tension de référence V_{REF} et le comparateur génère un signal de détection Vₒᵤₜ égal à VDD équivalent à un bit égal à « 1 ». Lorsque la jonction tunnel magnétique MTJ est à un état résistif bas P, la tension reçue par la première entrée du comparateur est supérieure à la tension de référence V_{REF} et le comparateur génère un signal de détection Vₒᵤₜ égal à 0, équivalent à un bit égal à « 0 ».

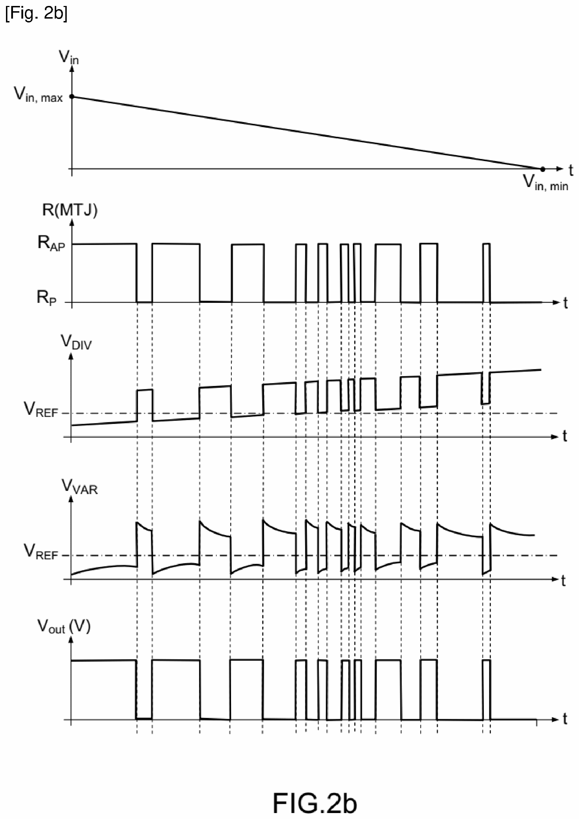

La figure 2b illustre la variation des différents signaux du générateur D1 de bit probabiliste selon un premier mode de réalisation de l'invention en réponse à une variation linéaire de la tension d'entrée Vᵢₙ. La tension d'entrée Vᵢₙ varie de manière linéaire décroissante entre les valeurs V_{in,max} et V_{in,min} préalablement définies. La résistance R(MTJ) de la jonction tunnel magnétique MTJ fluctue entre les deux états résistifs R_{AP} et R_{P} selon une probabilité qui dépend de la tension d'entrée Vᵢₙ. La tension V_{DIV} sur le premier nœud de détection NC1 suit de manière inverse les fluctuations de la résistance R (MTJ) tout en s'écartant de la tension de référence V_{REF}. La tension V_{VAR} sur le second nœud de détection NC2 reproduit les variations de la tension V_{DIV} tout en restant centrée sur la tension de référence V_{REF} grâce à l'élément capacitif C1. Par conséquent, le comparateur COMP génère un signal de détection Vₒᵤₜ qui reproduit les variations de la résistance R(MTJ) sur toute la plage dynamique [V_{in,min} - V_{in,max}].

Le circuit calculateur CALC est configuré pour générer un bit probabiliste à partir du signal de détection Vₒᵤₜ en déterminant la proportion de chaque état résistif de la jonction tunnel magnétique MTJ pendant une période prédéterminée. Le circuit calculateur est configuré pour calculer la distribution entre des bits à un état logique haut « 1 » et des bits à un état logique bas « 0 » dans une séquence de bits correspondant au signal de détection Vₒᵤₜ pendant une durée prédéterminée. Par exemple, le circuit calculateur CALC est configuré pour échantillonner le signal de détection Vₒᵤₜ chaque 1ns pendant une période de 10µs. Le nombre de bits à « 1 » (ou des bits à « 0 ») est calculé pendant la période de 10µs, ce qui correspond à un échantillon de 10000 bits logiques pour déterminer la proportion de bits à « 1 » et à « 0 » ce qui correspond au bit probabiliste p-bit = (P(1),P(0)).

Alternativement, le circuit calculateur CALC est configuré pour calculer la moyenne du signal de détection s1 sur la durée de la période. La moyenne est proportionnelle au nombre de bits égal à « 1 » sur la période échantillonnée.

Avantageusement, le générateur de bit probabiliste D1 comprend en outre un premier transistor de polarisation T_{P1} monté entre le second nœud de détection NC2 et le nœud d'alimentation VDD. Le premier transistor de polarisation T_{P1} étant commandé par une première tension de polarisation Vₚₒₗ appliquée sur sa grille. La première tension de polarisation Vₚₒₗ est générée par les moyens de contrôle CONT et elle est choisie pour maintenir le premier transistor de polarisation T_{P1} en régime de saturation. Le premier transistor de polarisation T_{P1} est dimensionné et polarisé de manière à polariser le mode commun de la tension V_{VAR} à une valeur comprise dans la plage [0.9xV_{REF} ; 1,1xV_{REF}].

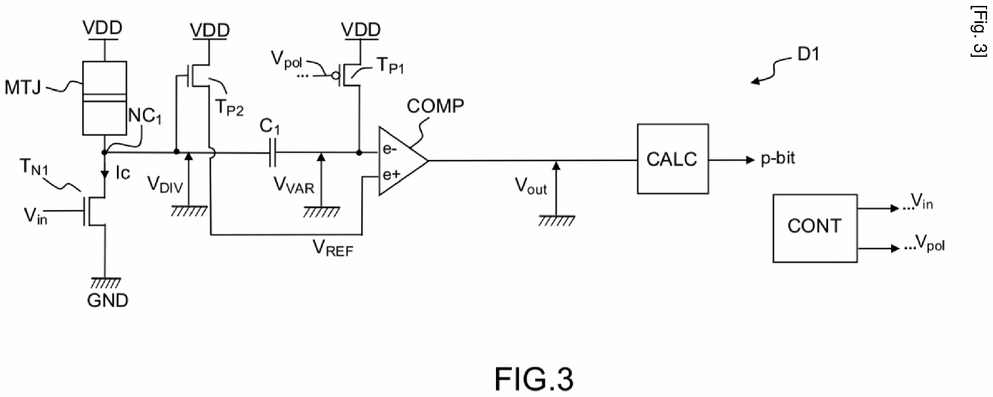

La figure 3 illustre un générateur D1 de bit probabiliste selon un deuxième mode de réalisation de l'invention. Le deuxième mode de réalisation reprend les mêmes caractéristiques et avantages techniques détaillés pour le premier mode de réalisation. Le générateur D1 selon le deuxième mode de réalisation comprend en outre un second transistor de polarisation T_{P2} monté entre la seconde entrée du comparateur COMP et le nœud d'alimentation VDD. La grille du second transistor de polarisation T_{P2} est connectée au premier nœud de détection NC1. Le transistor de polarisation T_{P2} est dimensionné pour fonctionner en régime de saturation en réponse à la tension V_{DIV} qui commande sa grille. Le drain du second transistor de polarisation T_{P2} fournit ainsi une tension de référence V_{REF} au comparateur COMP qui est moins sensible aux phénomènes de variabilités de procédé et/ou de températures. En effet, la variabilité du procédé dans un circuit intégré provient des variations inévitables dans la fabrication, comme les dimensions des transistors ou les dopants. La variabilité de température résulte des différences d'échauffement local dues à l'activité des composants et à la dissipation thermique. Ces facteurs influencent les performances et la fiabilité des circuits en créant des réponses différentes dans un même circuit. Etant donné qu'un circuit stochastique comprend une pluralité de dispositifs spintroniques selon l'invention, les problèmes de variabilités doivent être pris en compte lors de la conception. Contrairement à une tension de référence classique, la tension de référence V_{REF} dans le circuit de l'invention est spécifique au dispositif mesuré. La référence est directement extraite du dispositif lui-même. Cela signifie que la tension de référence est corrélée au dispositif, et que ses variations affectent tout le système de manière similaire, ce qui limite les erreurs. En cas de différences dues aux procédés de fabrication ou à la température, la tension de référence s'ajuste en conséquence. Ainsi, le générateur D1 de bit probabiliste selon un deuxième mode de réalisation permet d'atténuer les problèmes relatifs aux phénomènes de variabilité.

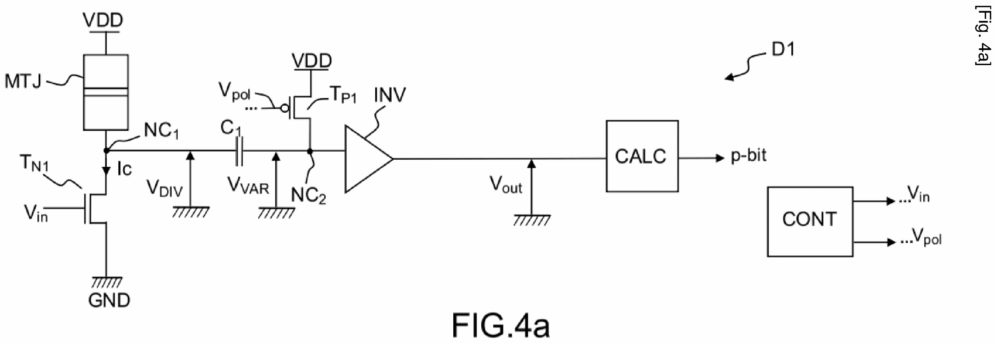

La figure 4a illustre un générateur D1 de bit probabiliste selon un troisième mode de réalisation de l'invention. Le troisième mode de réalisation reprend les mêmes caractéristiques et avantages techniques détaillés pour le premier mode de réalisation. Le générateur D1 selon le troisième mode de réalisation se distingue du premier mode de réalisation par l'implémentation du circuit de détection DET. Le circuit de détection DET est constitué d'un inverseur à la place du comparateur COMP. L'inverseur INV comprend une entrée e1 connectée au second nœud de détection NC2. Lorsque la jonction tunnel magnétique MTJ est à un état résistif haut AP, la tension reçue par l'inverseur est inférieure à sa tension seuil de commutation intrinsèque V_{COMMUT}. L'inverseur INV génère sur sa sortie un signal de détection Vₒᵤₜ égal à VDD, équivalent à un bit égal à « 1 ». Lorsque la jonction tunnel magnétique MTJ est à un état résistif bas P, la tension reçue par l'inverseur est supérieure à sa tension de commutation V_{COMMUT} et l'inverseur génère un signal de détection Vₒᵤₜ nul, équivalent à un bit égal à « 0 ».

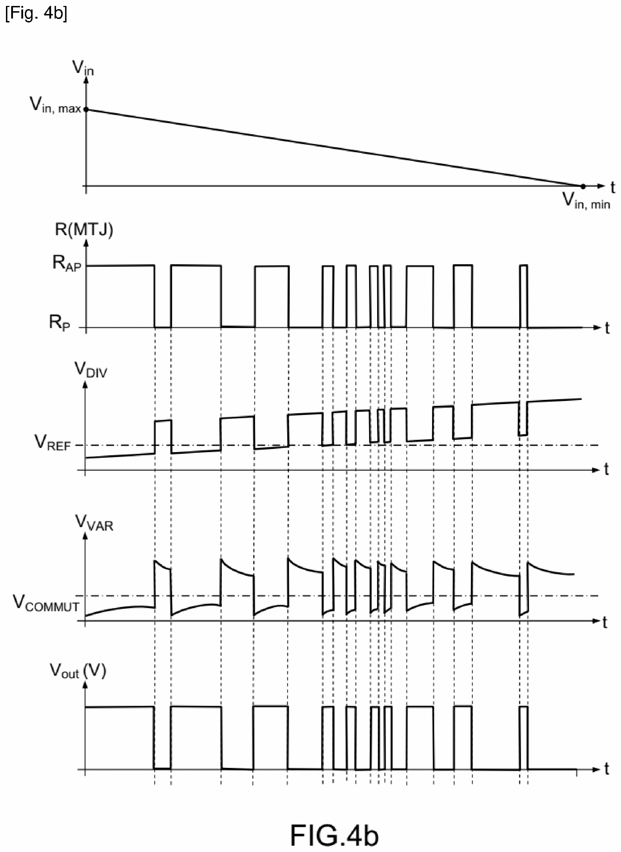

La figure 4b illustre la variation des différents signaux du générateur D1 de bit probabiliste selon un troisième mode de réalisation de l'invention en réponse à une variation linéaire de la tension d'entrée Vᵢₙ. Le générateur D1 de bit probabiliste selon le troisième mode de réalisation montre un comportement similaire à la réponse décrite à la figure 2b. La tension V_{VAR} sur le second nœud de détection NC2 reproduit les variations de la tension V_{DIV} tout en restant centrée sur la tension de commutation V_{COMMUT} grâce à l'élément capacitif C1. Par conséquent, l'inverseur INV génère un signal de détection Vₒᵤₜ qui reproduit les variations de la résistance R(MTJ) sur toute la plage dynamique [V_{in,min} - V_{in,max}].

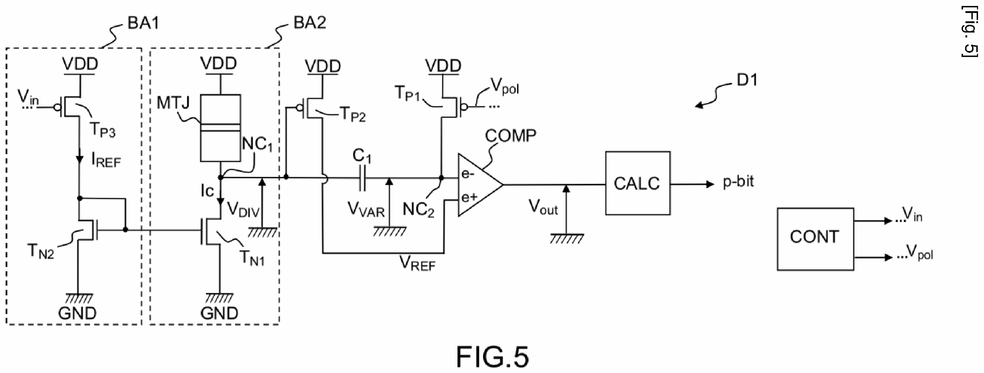

La figure 5 illustre un générateur D1 de bit probabiliste selon un quatrième mode de réalisation de l'invention. Le quatrième mode de réalisation reprend les mêmes caractéristiques et avantages techniques détaillés pour le premier mode de réalisation. Le générateur D1 selon le quatrième mode de réalisation comprend un miroir de courant apte à copier un courant de référence à travers la jonction tunnel magnétique MTJ avec une précision élevée. Le miroir de courant comprend une première branche d'alimentation BA1 couplée à une seconde branche d'alimentation BA2. La première branche comprend un transistor T_{P3} de type PMOS monté en série avec un transistor T_{N2} de type NMOS monté en diode. Le transistor T_{P3} reçoit la tension d'entrée Vᵢₙ sur sa grille pour fixer l'intensité de I_{REF} qui traverse la première branche d'alimentation BA1. La grille du transistor T_{N2} est connectée à celle du transistor de contrôle T_{N1} pour coupler les deux branches d'alimentation BA1, BA2.

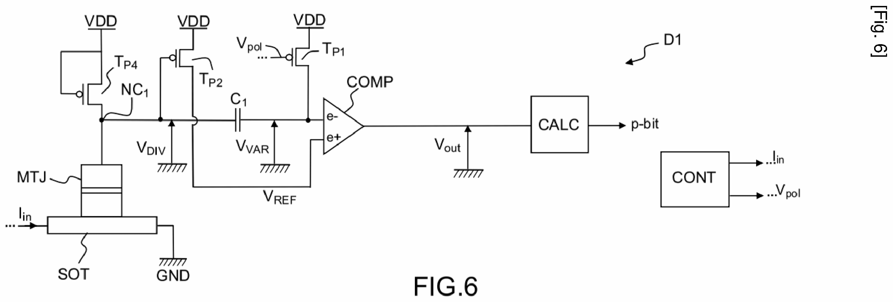

La figure 6 illustre un générateur D1 de bit probabiliste selon un cinquième mode de réalisation de l'invention. Le cinquième mode de réalisation reprend les mêmes caractéristiques et avantages techniques détaillés pour les modes de réalisation précédents. Dans le générateur D1 selon le cinquième mode de réalisation, la jonction tunnel magnétique MTJ est disposée sur une piste d'écriture SOT en un matériau à effet Hall de spin ou un matériau à effet Hall orbital. L'interface entre la jonction tunnel magnétique MTJ et la piste d'écriture SOT est du côté de la couche ferromagnétique libre. La direction de l'empilement formant la jonction tunnel magnétique MTJ est orthogonale au plan formé par la couche formant la piste d'écriture SOT. La piste d'écriture SOT est réalisée en un matériau à effet hall de spin (dénommé aussi matériau à effet de couple spin-orbite), par exemple le tungstène en phase béta ou l'antimoniure de bismuth ou un empilement de deux couches l'une en tantale et l'autre en tungstène ou un alliage BiSbTe. Les moyens de contrôle génèrent un courant d'écriture Iᵢₙ à travers la piste d'écriture SOT selon une direction. Cela induit des courants de spin qui interagissent avec la couche ferromagnétique libre. Cette interaction permet un contrôle de la direction de polarisation magnétique dans la couche ferromagnétique libre de la jonction MTJ selon la direction du courant d'écriture dans la piste d'écriture SOT. Le contrôle de la direction de polarisation magnétique dans la couche ferromagnétique libre permet de modifier la résistance électrique R(MTJ) de la jonction tunnel magnétique MTJ sans y injecter un courant d'écriture, ce qui augmente considérablement la robustesse du dispositif spintronique. La détection de l'état résistif se fait au niveau du second nœud de détection NC2 et non directement sur le premier nœud de détection NC1. L'élément capacitif C1 permet de résoudre les problèmes de lecture résultants de la dérive du mode commun du potentiel VDIV au niveau du premier nœud commun NC1.

Le dispositif spintronique selon l'invention exploite les propriétés stochastiques d'une jonction tunnel magnétique MTJ pour produire des bits aléatoires ou pseudo-aléatoires avec une distribution contrôlée. Contrairement aux générateurs classiques, il utilise une architecture de détection particulière permettant d'éliminer les effets de la dérive du mode commun de la tension au niveau du nœud de détection connecté directement à l'extrémité de la jonction tunnel magnétique MTJ. Cette solution permet une lecture des bits de manière plus fiable sur toute la plage dynamique de la tension d'entrée Vᵢₙ (ou du courant d'entrée Iᵢₙ). Cette innovation améliore fiabilité, la précision de détection et la robustesse face aux phénomènes de variabilité par rapport aux solutions existantes.

## Revendications

1. Dispositif spintronique (D1) comprenant :
- une jonction tunnel magnétique (MTJ) ayant une résistance qui fluctue entre au moins deux états résistifs distincts (P, AP) selon sa magnétisation ;
- un transistor de contrôle (T_{N1}) monté en série avec la jonction tunnel magnétique (MTJ) entre un nœud d'alimentation (VDD) et la masse électrique (GND) ; le nœud commun entre le transistor de contrôle (T_{N1}) et la jonction tunnel magnétique (MTJ) constituant un premier nœud de détection (NC1) ;
- un élément capacitif (C₁) connecté entre le premier nœud de détection (NC1) et un second nœud de détection (NC2) ;
- un circuit de détection (COMP, INV) ayant une première entrée (e-) connectée au second nœud de détection (NC2) et configuré pour générer un signal de détection (Vₒᵤₜ) variable selon l'état résistif de la jonction tunnel magnétique (MTJ) à partir du potentiel électrique (V_{VAR}) du second nœud de détection (NC2).

2. Dispositif spintronique (D1) selon la revendication 1 dans lequel le circuit de détection (COMP, INV) est configuré pour comparer le potentiel électrique (V_{VAR}) du second nœud de détection (NC2) avec une tension de seuil prédéterminée (V_{REF}, VCOMMUT).

3. Dispositif spintronique (D1) selon l'une quelconque des revendications 1 ou 2 comprenant en outre un premier transistor de polarisation (T_{P1}) monté entre le second nœud de détection (NC2) et le nœud d'alimentation (VDD) ; le premier transistor de polarisation (T_{P1}) étant commandé par une première tension de polarisation (Vₚₒₗ) appliquée sur sa grille et choisie pour maintenir le premier transistor de polarisation (T_{P1}) en régime de saturation.

4. Dispositif spintronique (D1) selon l'une quelconque des revendications 1 à 3 comprenant en outre un circuit calculateur (CALC) configuré pour générer un bit probabiliste à partir du signal de détection (Vₒᵤₜ) par échantillonnage ou par calcul de moyenne en déterminant la proportion de chaque état résistif de la jonction tunnel magnétique (MTJ) pendant une période prédéterminée.

5. Dispositif spintronique (D1) selon l'une quelconque des revendications 1 à 4 dans lequel la jonction tunnel magnétique (MTJ) est une jonction tunnel super-paramagnétique.

6. Dispositif spintronique (D1) selon l'une quelconque des revendications 1 à 5 dans lequel la jonction tunnel magnétique (MTJ) est disposée sur une piste d'écriture (SOT) en un matériau à effet Hall de spin ou un matériau à effet Hall orbital.

7. Dispositif spintronique (D1) selon l'une quelconque des revendications 2 à 6 en combinaison avec la revendication 2 dans lequel le circuit de détection (INV) est un inverseur (INV) et la tension de seuil prédéterminée est le seuil de commutation (V_{COMMUT}) dudit inverseur.

8. Dispositif spintronique (D1) selon l'une quelconque des revendications 2 à 6 dans lequel le circuit de détection (DET) est un comparateur (COMP) ayant une première entrée connectée au second nœud de détection (NC2) et une seconde entrée destinée à recevoir une tension de référence (V_{REF} ) et un nœud de sortie pour générer le signal de détection (Vₒᵤₜ).

9. Dispositif spintronique (D1) selon la revendication 8 comprenant en outre un second transistor de polarisation (T_{P2}) monté entre la seconde entrée du comparateur (COMP) et le nœud d'alimentation (VDD) ; la grille du second transistor de polarisation (T_{P2}) étant connectée au premier nœud de détection (NC1).

10. Dispositif spintronique (D1) selon l'une quelconque des revendications 1 à 9 dans lequel la capacité de l'élément capacitif (C₁) est inférieure ou égale à 20pF.

11. Dispositif spintronique (D1) selon l'une quelconque des revendications 1 à 10 dans lequel la capacité de l'élément capacitif (C₁) est comprise entre 5pF et 10pF.

12. Dispositif spintronique (D1) selon l'une quelconque des revendications 1 à 11 dans lequel la jonction tunnel magnétique (MTJ) comprend :
- une première couche (11) ferromagnétique de référence dans laquelle la direction de la polarisation magnétique est fixe ;
- une seconde couche (13) ferromagnétique dans laquelle la direction de la polarisation magnétique est variable ;
- une couche barrière tunnel (12) d'oxyde confinée entre la première et la seconde couche ferromagnétique (11,13).

13. Dispositif spintronique (D1) selon la revendication 12 dans lequel l'épaisseur de la seconde couche (13) est inférieure à 100 nm.

14. Dispositif spintronique (D1) selon l'une quelconque des revendications 12 ou 13 dans lequel le diamètre de la jonction tunnel magnétique (MTJ) est inférieur à 10 nm.

15. Dispositif spintronique (D1) selon l'une quelconque des revendications 1 à 14 comprenant un miroir de courant,
ledit miroir de courant comprenant une première branche d'alimentation (BA1) couplée à une seconde branche d'alimentation (BA2) ; la seconde branche d'alimentation (BA2) comprenant au moins le transistor de contrôle (T_{N1}) et la jonction tunnel magnétique (MTJ) montés en série.

## Patentansprüche

1. Spintronic-Vorrichtung (D1), umfassend:
- einen magnetischen Tunnelkontakt (MTJ), der einen Widerstand aufweist, der in Abhängigkeit von seiner Magnetisierung zwischen mindestens zwei unterschiedlichen Widerstandszuständen (P, AP) schwankt;
- einen Steuerungstransistor (T_{N1}), der in Reihe mit dem magnetischen Tunnelkontakt (MTJ) zwischen einem Zufuhrknoten (VDD) und der elektrischen Masse (GND) geschaltet ist, wobei der gemeinsame Knoten zwischen dem Steuerungstransistor (T_{N1}) und dem magnetischen Tunnelkontakt (MTJ) einen ersten Erfassungsknoten (NC1) darstellt;
- ein Kondensatorelement (C₁), das zwischen dem ersten Erfassungsknoten (NC1) und einem zweiten Erfassungsknoten (NC2) verbunden ist;
- eine Erfassungsschaltung (COMP, INV), die einen ersten Eingang (e-) aufweist, der mit dem zweiten Erfassungsknoten (NC2) verbunden ist, und so konfiguriert ist, dass sie ein Erfassungssignal (Vₒᵤₜ ), das in Abhängigkeit vom Widerstandszustand des magnetischen Tunnelkontakts (MTJ) variiert, ausgehend vom elektrischen Potenzial (V_{VAR}) des zweiten Erfassungsknotens (NC2) erzeugt.

2. Spintronic-Vorrichtung (D1) nach Anspruch 1, wobei die Erfassungsschaltung (COMP, INV) so konfiguriert ist, dass sie das elektrische Potenzial (V_{VAR}) des zweiten Erfassungsknotens (NC2) mit einer vorbestimmten Spannungsschwelle (V_{REF,} V_{COMMUT}) vergleicht.

3. Spintronic-Vorrichtung (D1) nach einem der Ansprüche 1 oder 2, weiter umfassend einen ersten Polarisationstransistor (T_{P1}), der zwischen dem zweiten Erfassungskonten (NC2) und dem Zufuhrknoten (VDD) angebracht ist, wobei der erste Polarisationstransistor (T_{P1}) durch eine erste Polarisationsspannung (Vₚₒₗ ) gesteuert wird, die an seinem Gate angelegt und ausgewählt wird, um den ersten Polarisationstransistor (T_{P1}) im Sättigungsbetrieb zu halten.

4. Spintronic-Vorrichtung (D1) nach einem der Ansprüche 1 bis 3, die weiter eine Rechenschaltung (CALC) umfasst, die so konfiguriert ist, dass sie ausgehend vom Erfassungssignal (Vₒᵤₜ ) durch Abtastung oder durch Mittelwertbildung unter Bestimmen des Anteils jedes Widerstandszustands des magnetischen Tunnelkontakts (MTJ) während eines vorbestimmten Zeitraums ein probabilistisches Bit erzeugt.

5. Spintronic-Vorrichtung (D1) nach einem der Ansprüche 1 bis 4, wobei der magnetische Tunnelkontakt (MTJ) ein superparamagnetischer Tunnelkontakt ist.

6. Spintronic-Vorrichtung (D1) nach einem der Ansprüche 1 bis 5, wobei der magnetische Tunnelkontakt (MTJ) auf einer Schreibfläche (SOT) aus einem Material mit Spin-Hall-Effekt oder einem Material mit Orbital-Hall-Effekt angeordnet ist.

7. Spintronic-Vorrichtung (D1) nach einem der Ansprüche 2 bis 6 in Kombination mit Anspruch 2, wobei die Erfassungsschaltung (INV) ein Umschalter (INV) ist und die vorbestimmte Spannungsschwelle die Umschaltschwelle (V_{COMMUT}) des Umschalters ist.

8. Spintronic-Vorrichtung (D1) nach einem der Ansprüche 2 bis 6, wobei die Erfassungsschaltung (DET) ein Komparator (COMP) ist, der einen ersten Eingang, der mit dem zweiten Erfassungsknoten (NC2) verbunden ist, und einen zweiten Eingang, der dazu bestimmt ist, eine Referenzspannung (V_{REF} ) zu empfangen, und einen Ausgangsknoten zum Erzeugen des Erfassungssignals (Vₒᵤₜ ) aufweist.

9. Spintronic-Vorrichtung (D1) nach Anspruch 8, weiter umfassend einen zweiten Polarisationstransistor (T_{P2}), der zwischen dem zweiten Eingang des Komparators (COMP) und dem Zufuhrknoten (VDD) angebracht ist, wobei das Gate des zweiten Polarisationstransistors (T_{P2}) mit dem ersten Erfassungsknoten (NC1) verbunden ist.

10. Spintronic-Vorrichtung (D1) nach einem der Ansprüche 1 bis 9, wobei die Kapazität des Kondensatorelements (C₁) kleiner oder gleich 20 pF ist.

11. Spintronic-Vorrichtung (D1) nach einem der Ansprüche 1 bis 10, wobei die Kapazität des Kondensatorelements (C₁) zwischen 5 pF und 10 pF beträgt.

12. Spintronic-Vorrichtung (D1) nach einem der Ansprüche 1 bis 11, wobei der magnetische Tunnelkontakt (MTJ) Folgendes umfasst:
- eine erste ferromagnetische Referenzschicht (11), wobei die Richtung der magnetischen Polarisation fest ist;
- eine zweite ferromagnetische Schicht (13), wobei die Richtung der magnetischen Polarisation variabel ist;
- eine Tunnelbarriereschicht (12) aus Oxid, die zwischen der ersten und der zweiten ferromagnetischen Schicht (11, 13) eingeschlossen ist.

13. Spintronic-Vorrichtung (D1) nach Anspruch 12, wobei die Dicke der zweiten Schicht (13) weniger als 100 nm beträgt.

14. Spintronic-Vorrichtung (D1) nach einem der Ansprüche 12 oder 13, wobei der Durchmesser des magnetischen Tunnelkontakts (MTJ) kleiner als 10 nm ist.

15. Spintronic-Vorrichtung (D1) nach einem der Ansprüche 1 bis 14, die einen Stromspiegel umfasst,
wobei der Stromspiegel einen ersten Zufuhrzweig (BA1) umfasst, der mit einem zweiten Zufuhrzweig (BA2) gekoppelt ist, wobei der zweite Zufuhrzweig (BA2) mindestens den Steuerungstransistor (T_{N1}) und den magnetischen Tunnelkontakt (MTJ) in Reihe geschaltet umfasst.

## Claims

1. A spintronic device (D1) comprising:
- a magnetic tunnel junction (MTJ) having a resistance which fluctuates between at least two distinct resistive states (P, AP) according to its magnetization;
- a control transistor (T_{N1}) connected in series with the magnetic tunnel junction (MTJ) between a supply node (VDD) and electrical ground (GND); the common node between the control transistor (T_{N1}) and the magnetic tunnel junction (MTJ) constituting a first detection node (NC1);
- a capacitive element (C₁) connected between the first detection node (NC1) and a second detection node (NC2);
- a detection circuit (COMP, INV) having a first input (e-) connected to the second detection node (NC2) and configured to generate a detection signal (Vₒᵤₜ ) that varies depending on the resistive state of the magnetic tunnel junction (MTJ) from the electrical potential (V_{VAR}) of the second detection node (NC2).

2. The spintronic device (D1) according to claim 1, wherein the detection circuit (COMP, INV) is configured to compare the electrical potential (V_{VAR}) of the second detection node (NC2) with a predetermined threshold voltage (V_{REF,} V_{COMMUT}).

3. The spintronic device (D1) according to any one of claims 1 or 2, further comprising a first bias transistor (T_{P1}) connected between the second detection node (NC2) and the supply node (VDD); the first bias transistor (T_{P1}) being controlled by a first bias voltage (Vₚₒₗ ) applied to its gate and chosen so as to keep the first bias transistor (T_{P1}) in saturation regime.

4. The spintronic device (D1) according to any one of claims 1 to 3, further comprising a computer circuit (CALC) configured to generate a probabilistic bit from the detection signal (Vₒᵤₜ ) by sampling or by mean calculation, by determining the proportion of each resistive state of the magnetic tunnel junction (MTJ) during a predetermined period.

5. The spintronic device (D1) according to any one of claims 1 to 4, wherein the magnetic tunnel junction (MTJ) is a superparamagnetic tunnel junction.

6. The spintronic device (D1) according to any one of claims 1 to 5, wherein the magnetic tunnel junction (MTJ) is arranged on a write track (SOT) made of a spin Hall effect material or an orbital Hall effect material.

7. The spintronic device (D1) according to any one of claims 2 to 6 in combination with claim 2, wherein the detection circuit (INV) is an inverter (INV) and the predetermined threshold voltage is the switching threshold (V_{COMMUT}) of said inverter.

8. The spintronic device (D1) according to any one of claims 2 to 6, wherein the detection circuit (DET) is a comparator (COMP) having a first input connected to the second detection node (NC2) and a second input intended to receive a reference voltage (V_{REF} ) and an output node for generating the detection signal (Vₒᵤₜ ).

9. The spintronic device (D1) according to claim 8, further comprising a second bias transistor (T_{P2}) connected between the second input of the comparator (COMP) and the supply node (VDD); the gate of the second bias transistor (T_{P2}) being connected to the first detection node (NC1).

10. The spintronic device (D1) according to any one of claims 1 to 9, wherein the capacitance of the capacitive element (C₁) is less than or equal to 20 pF.

11. The spintronic device (D1) according to any one of claims 1 to 10, wherein the capacitance of the capacitive element (C₁) is between 5 pF and 10 pF.

12. The spintronic device (D1) according to any one of claims 1 to 11, wherein the magnetic tunnel junction (MTJ) comprises:
- a first reference ferromagnetic layer (11) wherein the direction of the magnetic polarization is fixed;
- a second ferromagnetic layer (13) wherein the direction of the magnetic polarization is variable;
- an oxide tunnel barrier layer (12) confined between the first and the second ferromagnetic layer (11, 13).

13. The spintronic device (D1) according to claim 12, wherein the thickness of the second layer (13) is less than 100 nm.

14. The spintronic device (D1) according to any one of claims 12 or 13, wherein the diameter of the magnetic tunnel junction (MTJ) is less than 10 nm.

15. The spintronic device (D1) according to any one of claims 1 to 14, comprising a current mirror,
said current mirror comprising a first supply branch (BA1) coupled to a second supply branch (BA2); the second supply branch (BA2) comprising at least the series-connected control transistor (T_{N1}) and magnetic tunnel junction (MTJ).
